(19)

Europäisches
Patentamt
European
Patent Office
Office européen
des brevets

(11)    **EP 1 923 131 A1**

(12)    **EUROPEAN PATENT APPLICATION**
published in accordance with Art. 153(4) EPC

(43) Date of publication:
**21.05.2008 Bulletin 2008/21**

(21) Application number: **05780407.2**

(22) Date of filing: **12.08.2005**

(51) Int Cl.:
**B01J 19/08** (2006.01)        **B82B 3/00** (2006.01)
**G01N 37/00** (2006.01)

(86) International application number:
**PCT/JP2005/015103**

(87) International publication number:
**WO 2007/020703 (22.02.2007 Gazette 2007/08)**

(84) Designated Contracting States:
**AT BE BG CH CY CZ DE DK EE ES FI FR GB GR
HU IE IS IT LI LT LU LV MC NL PL PT RO SE SI
SK TR**

(71) Applicant: **Toyo University Educational
Foundation
Tokyo 112-8606 (JP)**

(72) Inventors:
• **MAEKAWA, Toru
Kawagoe-shi, Saitama 350-8585 (JP)**

• **MORIMOTO, Hisao
Kawagoe-shi, Saitama 350-8585 (JP)**
• **NAGAOKA, Yutaka
Kawagoe-shi, Saitama 350-8585 (JP)**

(74) Representative: **Müller-Boré & Partner
Patentanwälte
Grafinger Strasse 2
81671 München (DE)**

(54)    **METHOD OF MANIPULATION BY ROTATIONAL MAGNETIC FIELD**

(57)    A rotational magnetic field is applied to a base material having a paramagnetic property, a ferromagnetic property, or a diamagnetic property, and to a magnetic-particle containing substance that contains at least one magnetic particle and is placed on the base material. The magnetic particle also has a paramagnetic property, a ferromagnetic property, or a diamagnetic property. With the rotational magnetic field being applied, the magnetic dipole in the magnetic particle is rotated, and the magnetic-particle containing substance that contains the magnetic particle is moved on the base material by the magnetic dipole interaction between the magnetic particle and the base material. Thus, a manipulation method that utilizes a rotational magnetic field to perform manipulation readily at low costs is provided.

FIG. 2

EP 1 923 131 A1

**Description**

BACKGROUND OF THE INVENTION

Field of the Invention

The present invention relates to a method for manipulation using a rotational magnetic field. More particularly, the present invention relates to a method for manipulation using a rotational magnetic field by which a magnetic-particle containing substance or nonmagnetic particles can be readily manipulated on a base material at low costs.

Related Art

To perform manipulation of magnetic microparticles such as capturing and moving of magnetic microparticles having ferromagnetic properties, paramagnetic properties, or diamagnetic properties, a laser beam is emitted onto the magnetic microparticles to be moved, and the magnetic particles are trapped (captured) and moved. There have been laser manipulation devices that perform such operations. However, the laser manipulation devices are very expensive, and give thermal damage to magnetic microparticles. Thermal damage causes problems especially in a case where biomolecules modified with particles are to be manipulated. Therefore, the laser manipulation devices are not so suited for practical use.

There has also been a known method for manipulation using an electric field. However, by manipulation using an electric field, not only the magnetic particles to be moved but also all other particles are moved due to electrophoresis, or an electroosmotic flow might be caused. Therefore, it has been difficult to move only desired magnetic microparticles.

There has also been a known method for controlling movement of nonmagnetic particles by applying a rotational magnetic field to the nonmagnetic particles in a ferromagnetic fluid (G. Helgesen,. Pieranski, "Dynamic behavior of simple magnetic hole systems", Physical Review A 42, p.p. 7271-7280, 1990). By this method, however, attention is paid only to the rotational movement of nonmagnetic particles or the chain-like cluster formed with magnetic holes, and manipulation of nonmagnetic particles has not been specifically analyzed.

SUMMARY OF THE INVENTION

The present invention has been made in view of these circumstances, and an object thereof is to provide a method for manipulation using a rotational magnetic field by which only a magnetic-particle containing substance or nonmagnetic particles to be moved can be moved readily at low costs, and a magnetic-particle containing substance that contains magnetic particles such as molecules or nonmagnetic particles can be manipulated.

To achieve the above object, the first aspect of the present invention provides a method for manipulation using a rotational magnetic field, the method comprising: applying a rotational magnetic field to a base material having a paramagnetic property, a ferromagnetic property, or a diamagnetic property, and to a magnetic-particle containing substance that contains a magnetic particle and is placed on the base material, the magnetic particle having a paramagnetic property, a ferromagnetic property, or a diamagnetic property, thereby rotating a magnetic dipole in the magnetic particle and moving the magnetic-particle containing substance on the base material by a magnetic dipole interaction between the magnetic particle and the base material.

In the second aspect of the present invention, the base material is a material having a paramagnetic property or a ferromagnetic property, if the magnetic particles contained in the magnetic-particle containing substance to be moved on the base material have a paramagnetic property or a ferromagnetic property.

In the third aspect of the present invention, the base material is a material having a diamagnetic property, if the magnetic particles contained in the magnetic-particle containing substance to be moved on the base material have diamagnetic properties.

In the fourth aspect of the present invention, the magnetic particles are 1 nm or greater in particle size.

In the fifth aspect of the present invention, the rotational direction of the rotational magnetic field is changed so as to change the moving direction of the magnetic-particle containing substance on the base material.

In the sixth aspect of the present invention, a single magnetic particle is moved on a base material having convexities and concavities of a size equal to or larger than the radius of the single magnetic particle.

In the seventh aspect of the present invention, the magnetic-particle containing substance is a single magnetic particle, a plurality of magnetic particles, a cluster of magnetic particles, a magnetic-atom containing fullerene, or a magnetic-atom containing nanotube.

The eighth aspect of the present invention provides a method for manipulation using a rotational magnetic field by which a rotational magnetic field is applied to nonmagnetic particles placed in a magnetic fluid on a nonmagnetic base material, so as to induce an apparent magnetic dipole moment in the opposite direction from the rotational magnetic field in the nonmagnetic particles, and to move the nonmagnetic particles on the nonmagnetic base material.

In the ninth aspect of the present invention, the magnetic fluid has ferromagnetic particles of 1 nm to 10 nm dispersed in a liquid solvent.

As described above, the present invention can provide a method for manipulation using a rotational magnetic field by which only a magnetic-particle containing substance or nonmagnetic particles to be moved can be moved readily at low costs, and a magnetic-particle containing substance that contains magnetic particles such as molecules or nonmagnetic particles can be manipulated.

BRIEF DESCRIPTION OF THE DRAWINGS

Fig. 1 is a cross-sectional view showing an embodiment of electromagnets that generate a rotational magnetic field to be used by a method for manipulation using a rotational magnetic field in accordance with the present invention;

Figs. 2(a) to 2(d) illustrate an embodiment of the method for manipulation using a rotational magnetic field in accordance with the present invention;

Figs. 3(a) to 3(c) illustrate an example case to which the method for manipulation using a rotational magnetic field in accordance with the present invention cannot be applied;

Fig. 4 is a graph showing the relationship between the rotation angle of the magnetic dipole moment and the potential energy in the case shown in Fig. 3;

Figs. 5(a) to 5(c) illustrate another embodiment of the method for manipulation using a rotational magnetic field in accordance with the present invention;

Fig. 6 is a graph showing the relationship between the movement of two magnetic particles and the magnetic field intensity and the magnetic field frequency in a case to which the method for manipulation using a rotational magnetic field in accordance with the present invention is applied;

Fig. 7 illustrates yet another embodiment of the method for manipulation using a rotational magnetic field in accordance with the present invention;

Fig. 8(a) shows an experiment on manipulation of a cluster formed with two paramagnetic particles;

Fig. 8(b) shows an experiment on manipulation of a cluster formed with five paramagnetic particles;

Fig. 8(c) shows an experiment on manipulation of a cluster formed with a large number of paramagnetic particles;

Fig. 8(d) shows an experiment on manipulation of a cluster formed with two nonmagnetic particles;

Fig. 9 shows an experiment on manipulation of an iron-atom containing carbon nanotube along paramagnetic particles; and

Fig. 10 shows an experiment on manipulation of red blood cells.

DESCRIPTION OF THE EMBODIMENTS

The present invention is characterized as above, and the following is a description of embodiments of the present invention. It should be understood that the present invention is not limited to the following embodiments, and various modifications may be made to them.

By a method for manipulation using a rotational magnetic field in accordance with the present invention, a rotational magnetic field is applied to a base material that exhibits a paramagnetic property, a ferromagnetic property, or a diamagnetic property, and to a magnetic-particle containing substance containing magnetic particles that exhibit a paramagnetic property, a ferromagnetic property, or a diamagnetic property, placed on the base material. By doing so, the magnetic dipole in the magnetic particles is rotated, and the magnetic-particle containing substance containing the magnetic particles is moved on the base material by virtue of the magnetic dipole interaction between the magnetic particle and the base material. This characterizes the manipulation method of the present invention.

In the present invention, a "magnetic-particle containing substance" is a material that contains magnetic particles or another magnetic-particle containing substance, or is simply a magnetic particle or a plurality of magnetic particles.

A "base material" is any material that serves as a base for moving a magnetic-particle containing substance.

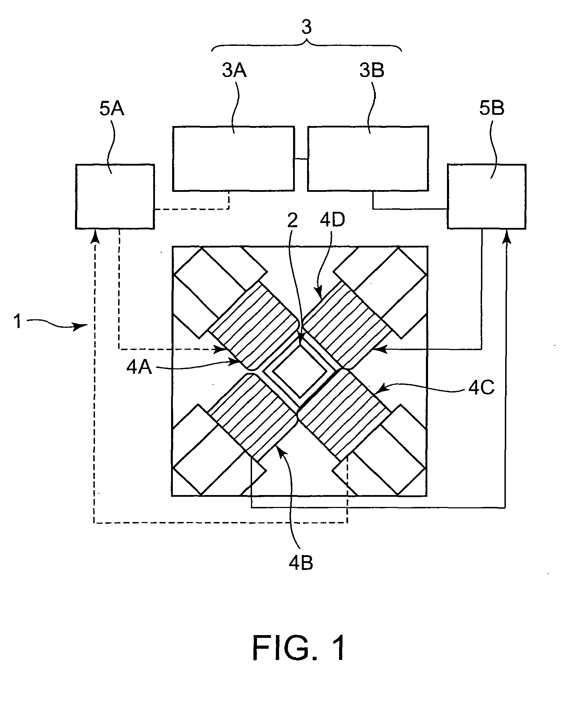

A "rotational magnetic field" has a uniform field direction that rotates with time. Such a rotational magnetic field may be generated by rotating a permanent magnet, or may be generated by the method illustrated in Fig. 1. As shown in Fig. 1, a sample (2) is placed on electromagnets (1) in the center, and the phases of the coil current of the coils (4A), (4B), (4C), and (4D) of the electromagnets (1) are changed by the master (3A) and the slave (3B) of a function generator (3). Between these two methods, the latter is more preferred, because the magnetic field intensity can be changed. In Fig. 1, reference numerals (5A) and (5B) indicate power amplifiers.

The magnetic field rotating frequency suitable for manipulating a magnetic-particle containing substance that contains magnetic particles varies with the mass of the magnetic particles, the particle size, the particle form (such as nanotubes), the particle magnetic dipole moment, the base magnetic dipole moment, or the viscosity coefficient of a solvent in a case where the magnetic-particle containing substance is in the solvent. The magnetic dipole rotates following the rotational magnetic field up to very high frequency, and the magnetic-particle containing substance moves by virtue of the attracting force between the magnetic dipole moments. However, the magnetic-particle containing substance does not move, unless the movement relaxation time of the magnetic-particle containing substance is shorter than the varying time of the magnetic dipole. In other words, the cycle of the rotational magnetic field needs to be longer than the time required for movement of the magnetic-particle containing substance (or the rotating frequency needs to be low).

For example, in a case where the magnetic-particle containing substance that contains magnetic particles is in a solvent, the resistance to movement of the magnetic-particle containing substance is the viscosity resistance from the solvent (the viscosity resistance depends on the viscosity of the solvent and the particle size), the oscillation caused by the solvent molecules (Brownian motion), or the particle mass. The attracting force between the particles depends on the size of the magnetic dipole moments. In a case where the magnetic particles contained in the magnetic-particle containing substance are of a paramagnetic material, the size of the magnetic dipole moments depends on the magnetic field intensity.

The method for manipulation using a rotational magnetic field in accordance with the present invention can be of course used in a vacuum or in the air or a gas, and can also be used in a liquid (solvent) such as water or oil.

As described above, a rotational magnetic field is applied to a magnetic-particle containing substance on a base material, and the magnetic dipole in the magnetic particles contained in the magnetic-particle containing substance is rotated. In this manner, the magnetic dipole interaction between the magnetic particle and the base material is utilized, and manipulation of the magnetic-particle containing substance on the base material can be performed more easily and at lower costs than manipulation by a conventional laser manipulation technique. Also, there is no thermal damage caused by the method in accordance with the present invention. Therefore, it is safe to say that the method in accordance with the present invention is a very effective method for biomolecule-modified manipulating particles without thermal damage to the biomolecules. Also, movement of all particles due to electrophoresis that is observed in manipulation performed with an electric field can be prevented, and only the magnetic-particle containing substance to be moved on the base material can be moved.

In a case where the magnetic particles contained in the magnetic-particle containing substance to be moved on the base material exhibit paramagnetic properties or ferromagnetic properties, it is preferable that the base material is a magnetic solid material or a magnetic thin film having a paramagnetic property or a ferromagnetic property. It is more preferable that the base material is a paramagnetic material, causing no residual magnetization. In a case where the magnetic particles contained in the magnetic-particle containing substance to be moved on the base material exhibit a diamagnetic property, it is possible that the base material is a diamagnetic solid material or a diamagnetic thin film having a diamagnetic property. In a case where the magnetic-particle containing substance to be moved is a single magnetic particle, the single magnetic particle can be moved on a base material having convexities and concavities equal to or larger than the radius of the magnetic particle. Further, in a case where nonmagnetic particles are to be manipulated, a base material made of a nonmagnetic material can be employed.

By the method for manipulation using a rotational magnetic field in accordance with the present invention, preferred manipulation of a magnetic-particle containing substance that contains magnetic particles can be performed, if the particle size of the magnetic particles is 1 nm or greater. Also, the moving direction of the magnetic-particle containing substance on the base material can be changed by changing the rotational direction of the rotational magnetic field to be applied to the base material and the magnetic particles.

The method for manipulation with a rotational magnetic field in accordance with the present invention can be preferably used for a single magnetic particle, a plurality of magnetic particles, a cluster of magnetic particles, a magnetic-atom containing fullerene, or a magnetic-atom containing nanotube.

By the method for manipulation using a rotational magnetic field in accordance with the present invention, magnetic particles have translational movement due to a rotational magnetic field. Accordingly, the surface of magnetic particles is modified with various molecules such as biomolecules, and the molecules can be then manipulated. Further, manipulation of a magnetic-atom containing fullerene or nanotube can be performed, and applications of those to drug deliveries or the likes can be expected.

Also, by the method for manipulation using a rotational magnetic field in accordance with the present invention, a rotational magnetic field may be applied to nonmagnetic particles placed in a magnetic fluid on a nonmagnetic base material, so as to induce an apparent magnetic dipole moment in the opposite direction from the rotational magnetic field in the nonmagnetic particles, and to move the nonmagnetic particles on the nonmagnetic base material. For example, nonmagnetic particles of polystyrene or the like can be moved along a nonmagnetic base material. In such a case, a magnetic fluid having ferromagnetic particles of 1 nm to 10 nm dispersed in a liquid solvent should be used so as to move the nonmagnetic particles along the nonmagnetic base material.

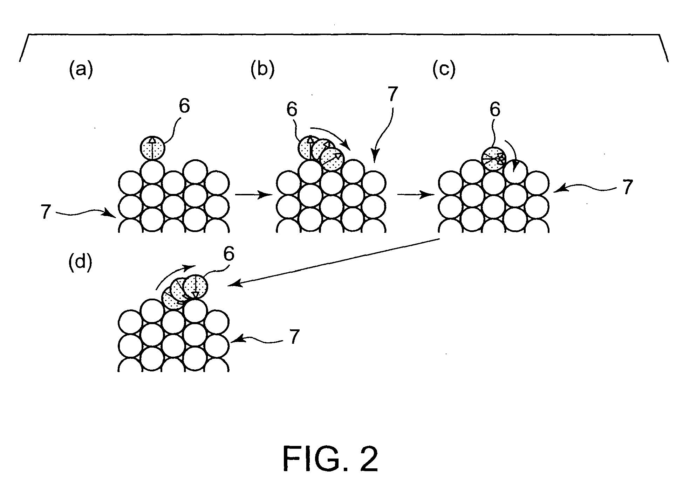

Figs. 2(a) to 2(d) illustrate an embodiment of the method for manipulation with a rotational magnetic field in accordance with the present invention. As shown in Figs. 2(a) to 2(d), to manipulate a single magnetic particle (6) on a base material (7), there should be convexities and concavities of a size equal to or greater than the radius of the magnetic particle (6) on the surface of the magnetic base material (7) on which the magnetic particle (6) is to be manipulated. With the base material (7), the magnetic dipole moment in the magnetic particle (6) can be rotated by a rotational magnetic field, and the magnetic particle (6) can be moved or manipulated by virtue of the interaction between the magnetic dipoles. In the case illustrated in Figs. 2(a) to 2(d), an upward magnetic dipole moment is induced in the single magnetic particle (6) on the base material (7) by a rotational magnetic field, as shown in Fig. 2(a). A magnetic dipole moment is also induced in the base material (7), and an interaction between magnetic dipoles is caused between the magnetic particle (6) and the base material (7). As the magnetic dipole in the magnetic particle (6) is rotated by a rotational magnetic field, the magnetic dipole moment in the magnetic particle (6) is rotated. Accordingly, the magnetic particle (6) can be moved to a stable position with low potential energy.

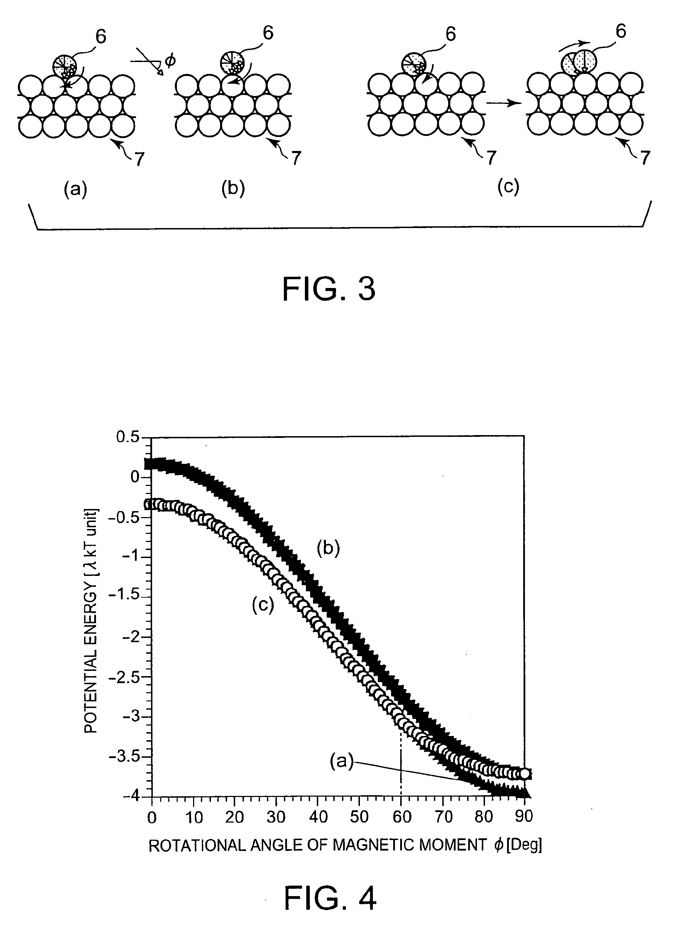

In a case where the surface of the base material (7) is smooth, or where there are no convexities and concavities of the size equal to or greater than the particle radius on the surface of the base material (7), the potential energy becomes higher with movement, and the single magnetic particle cannot be manipulated. More specifically, as shown in Figs. 3(a) to 3(c), the potential energy is the lowest, when the magnetic particle 6 is located in the position shown in Fig. 3(a) on the base material (7), and the magnetic dipole moment is rotated. When the magnetic particle (6) is located in the position shown in Fig. 3(b) on the base material (7), and the magnetic dipole moment is rotated, the potential energy is higher than that in the case where the magnetic dipole moment is rotated in the position shown in Fig. 3(a). As shown in Fig. 3(c), if the magnetic particle (6) has translational movement, the potential energy becomes higher than that in the case of Fig. 3(a), once the magnetic dipole moment becomes larger than a certain angle. In this manner, as the single particle (6) moves on the smooth base material (7), the potential energy becomes higher. Therefore, a single magnetic particle cannot be manipulated on a smooth base material.

Fig. 4 shows the relationship between the system's potential energy ($\lambda kT$) and the rotation angle $\varphi$ of the magnetic dipole moment in the cases illustrated in Figs. 3(a) to 3(c). Here, $\lambda$ represents the ratio between the dipole interaction energy and the thermal energy, k represents the Boltzmann constant, and T represents the absolute temperature. The black triangles in Fig. 4 form a graph showing the case of Fig. 3(a), the black squares form a graph showing the case of Fig. 3(b), and the white circles form a graph showing the case of Fig. 3(c). As is apparent from the graphs 4(a) to (c), the potential energy in the case (a) is smaller than that in the cases (b) and (c), when the rotation angle of the magnetic dipole moment is large. Therefore, it is clear that the case (a) is more stable than the cases of (b) and (c), and the single magnetic particle 6 cannot move on a smooth base material.

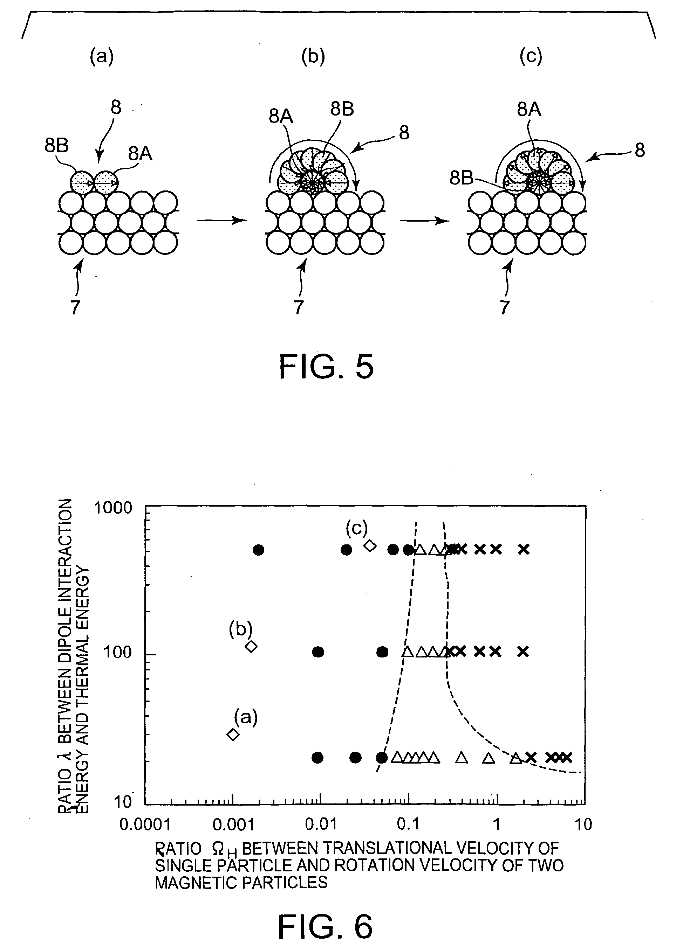

Figs. 5(a) to 5(c) illustrate a case where two magnetic particles are to be manipulated. As shown in Figs. 5(a) to 5(c), a rotational magnetic field is applied, so as to rotate the magnetic dipole moment of two magnetic particles 8. In this case, with one magnetic particle 8(a) of the two magnetic particles 8 being the center, the other magnetic particle 8(b) is rotated around the magnetic particle 8(a). After that, the magnetic particle 8(a) is rotated around the magnetic particle 8(b). These two processes are repeated, so that the two magnetic particles 8 can be manipulated, regardless of the convexities and concavities on the surface of the base material 7.

Fig. 6 shows the relationship between the movement of two magnetic particles, and the magnetic field intensity and the magnetic field frequency. In Fig. 6, the abscissa axis indicates the ratio $\Omega_H$ between the translational velocity of a single particle and the rotational velocity of two magnetic particles, and the ordinate axis indicates the ratio $\lambda$ between the dipole interaction and the thermal energy. Here, $\lambda$ and $\Omega_H$ can be expressed by the following equations (I) and (II), respectively:

$$\lambda \equiv \frac{|m|^2}{4\pi\mu_0 d^3 kT} \qquad \cdot\cdot\cdot \ (I)$$

$$\Omega_H \equiv \frac{2\pi^2 \mu_0 \eta_0 d^6 \omega}{|m|^2} \qquad \cdot\cdot\cdot (II)$$

where m, $\mu_0$, d, k, T, $\eta_0$, and $\omega$ represent the particle(s) or the magnetic moment induced in the particle(s), the magnetic permeability of the solvent (equal to the magnetic permeability of vacuum), the particle size, the Boltzmann constant, the absolute temperature, the viscosity coefficient of the solvent, and the angular frequency of the rotational magnetic field, respectively.

Here, the relationship between the size of the magnetic dipole moment |m| and the magnetic field $H_0$ is expressed by the following equation (III):

$$| m |= \frac{1}{18} md^3 \chi H_0 \qquad \cdot \cdot \cdot \quad (\text{III})$$

where $\chi$ represents the magnetic susceptibility.

In Fig. 6, the two magnetic particles can be manipulated in the regions indicated by black circles, and movement of the two magnetic particles is chaotic in the regions indicated by the white triangles. The two magnetic particles do not move in the regions indicated by $\times$.

For example, in a case where T (absolute temperature) is 300 K, and $\eta_0$ (the viscosity coefficient of the solvent) is $1 \times 10^{-3}$ Pa $\cdot$ s, the lozenges (a) to (c) in Fig. 6 satisfy the following conditions:

(a) d (particle size) = $5 \times 10^{-8}$ m,
$\chi$ (magnetic permeability) = $4.4 \times 10^{-6}$ H/m,
$H_0$ (magnetic field) = $1.59 \times 10^5$ A/m (B = 0.2T),
f (angular frequency/$2\pi$) = $\omega/(2\pi)$ = 100 Hz
(b) d = $2 \times 10^{-7}$ m,
$\chi$ = $4.4 \times 10^{-6}$ H/m,
$H_0$ = $3.98 \times 10^4$ A/m (B = 0.05T),
f = 10 Hz
(c) d = $2 \times 10^{-6}$ m,
$\chi$ = $5.0 \times 10^{-7}$ H/m,
$H_0$ = $2.39 \times 10^4$ A/m (B = 0.03T),
f = 1 Hz

As is apparent from the above examples, by the method for manipulation using a rotational magnetic field in accordance with the present invention, a rotational magnetic field is applied to a magnetic-particle containing substance on a base material, and the magnetic dipole in the magnetic particles contained in the magnetic-particle containing substance is rotated. In this manner, the magnetic dipole interaction between the magnetic particle and the base material is utilized, and manipulation of the magnetic-particle containing substance on the base material can be performed more easily and at lower costs than manipulation by a conventional laser manipulation technique. Also, movement of all particles due to electrophoresis that is observed in manipulation performed with an electric field can be prevented, and only the magnetic-particle containing substance to be moved on the base material can be moved.

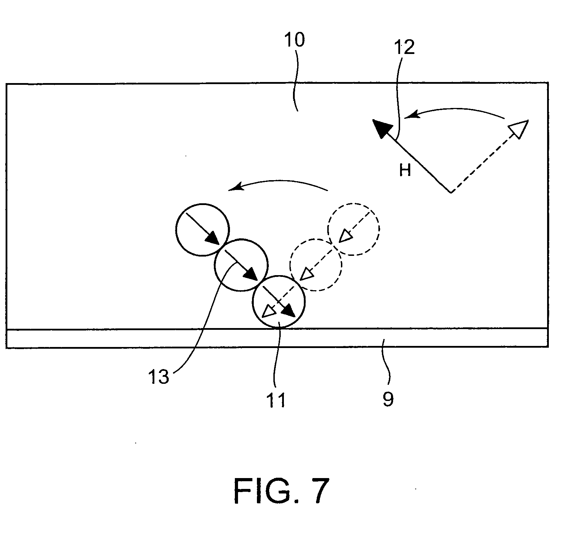

In a case of nonmagnetic particles, as shown in Fig. 7, a rotational magnetic field (12) is applied to nonmagnetic particles (11) (three nonmagnetic particles aligned in a chain-like state in Fig. 7) placed in a magnetic fluid (10) on a nonmagnetic base material (9), so as to induce an apparent magnetic dipole moment (13) in the opposite direction from the rotational magnetic field (12) in the nonmagnetic particles (11). In this manner, the nonmagnetic particles (11) are moved on the nonmagnetic base material (9). Here, it is preferable that the magnetic fluid (10) has ferromagnetic particles of 1 nm to 10 nm dispersed in a liquid solvent.

As described above, manipulation of nonmagnetic particles can be performed with a rotational magnetic field in the same manner as in a case of a magnetic-particle containing substance.

Next, several experiments that were actually carried out are described.

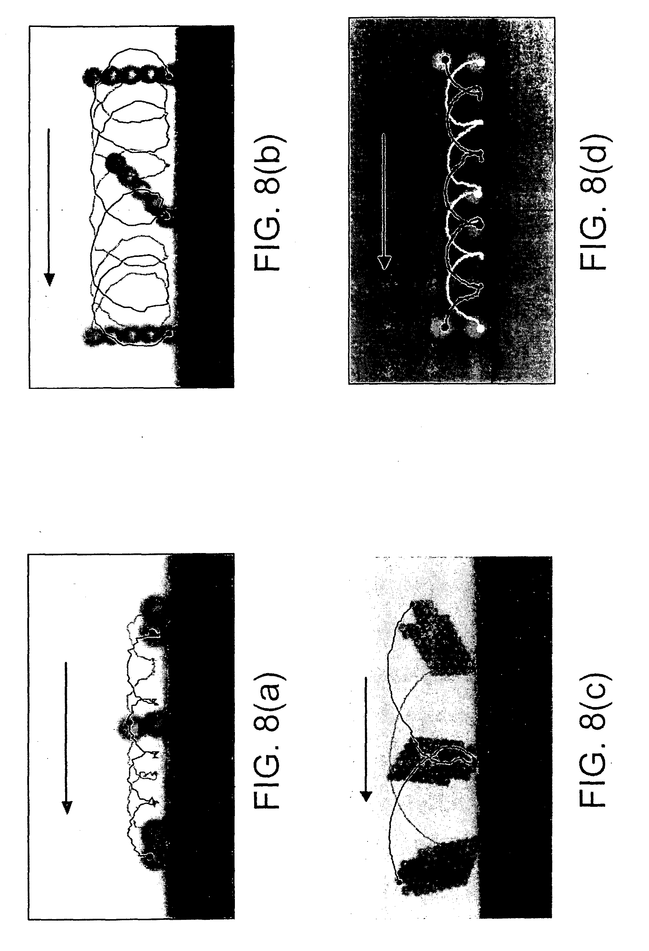

Fig. 8(a) shows an experiment on manipulation of a cluster formed with two paramagnetic particles. The paramagnetic particles were magnetite ($Fe_3O_4$) particles of 2.8 $\mu$m in particle size. The rotational magnetic field frequency was 1 Hz.

Fig. 8(b) shows an experiment on manipulation of a cluster formed with five paramagnetic particles. The paramagnetic particles were magnetite particles of 2.8 $\mu$m in particle size. The rotational magnetic field frequency was 1 Hz.

Fig. 8(c) shows an experiment on manipulation of a cluster formed with a large number of paramagnetic particles. The paramagnetic particles were magnetite particles of 2.8 $\mu$m in particle size. The rotational magnetic field frequency was 0.1 Hz.

Fig. 8(d) shows an experiment on manipulation of a cluster formed with two nonmagnetic particles. The nonmagnetic particles were polystyrene particles of 6.0 $\mu$m in particle size. The rotational magnetic field frequency was 0.1 Hz. The nonmagnetic particles were dispersed in a magnetic fluid (having 10-nm magnetite particles dispersed in a water solvent), and an apparent dipole is induced in the nonmagnetic particles.

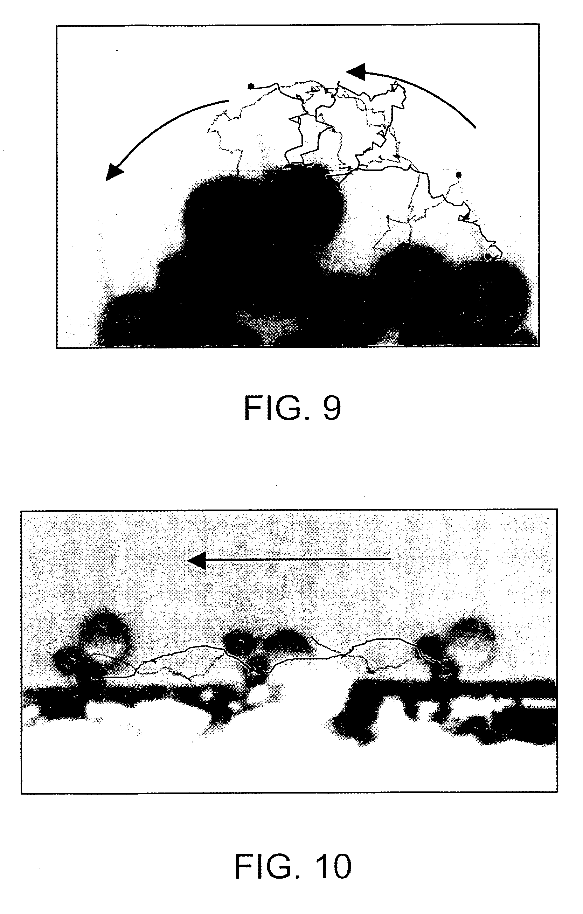

Fig. 9 shows an experiment on manipulation of an iron-atom containing carbon nanotube along paramagnetic particles (magnetite particles of 4.5 $\mu$m in particle size). The rotational magnetic field frequency was 0.5 Hz.

Fig. 10 is an experiment on manipulation of red blood cells. Two paramagnetic particles are attached to red blood cells, so as to manipulate cells. The paramagnetic particles were magnetite particles of 2.0 $\mu$m in particle size,

and the red blood cells were of sheep. The rotational magnetic field frequency was 0.5 Hz.

<u>INDUSTRIAL APPLICABILITY</u>

As described so far, the present invention provides a method for manipulation using a rotational magnetic field to manipulate a magnetic-particle containing substance or nonmagnetic particles readily on a base material at low costs. By this method, manipulation of various molecules such as biomolecules modified with the surfaces of magnetic particles can be performed. Further, manipulation of magnetic-atom containing fullerenes and nanotubes and nonmagnetic particles can be performed. Thus, applications of this method to drug deliveries and the likes can be expected.

**Claims**

1. A method for manipulation using a rotational magnetic field, the method comprising:

   applying a rotational magnetic field to a base material having a paramagnetic property, a ferromagnetic property, or a diamagnetic property, and to a magnetic-particle containing substance that contains a magnetic particle and is placed on the base material, the magnetic particle having a paramagnetic property, a ferromagnetic property, or a diamagnetic property, thereby rotating a magnetic dipole in the magnetic particle and moving the magnetic-particle containing substance on the base material by a magnetic dipole interaction between the magnetic particle and the base material.

2. The method for manipulation using a rotational magnetic field according to claim 1, wherein the base material is a material having a paramagnetic property or a ferromagnetic property, when the magnetic particle contained in the magnetic-particle containing substance to be moved on the base material has a paramagnetic property or a ferromagnetic property.

3. The method for manipulation using a rotational magnetic field according to claim 1, wherein the base material is a material having a diamagnetic property, when the magnetic particle contained in the magnetic-particle containing substance to be moved on the base material has a diamagnetic property.

4. The method for manipulation using a rotational magnetic field according to any of claims 1 to 3, wherein the magnetic particle is 1 nm or greater in particle size.

5. The method for manipulation using a rotational magnetic field according to any of claims 1 to 4, wherein the moving direction of the magnetic-particle containing substance on the base material is changed by changing the rotational direction of the rotational magnetic field.

6. The method for manipulation using a rotational magnetic field according to any of claims 1 to 5, wherein a single magnetic particle is moved on the base material having convexities and concavities of a size equal to or larger than the radius of the single magnetic particle.

7. The method for manipulation using a rotational magnetic field according to any of claims 1 to 6, wherein the magnetic-particle containing substance is one of a single magnetic particle, a plurality of magnetic particles, a cluster of magnetic particles, a magnetic-atom containing fullerene, and a magnetic-atom containing nanotube.

8. A method for manipulation using a rotational magnetic field, the method comprising:

   applying a rotational magnetic field to a nonmagnetic particle placed in a magnetic fluid on a nonmagnetic base material, thereby inducing an apparent magnetic dipole moment in the opposite direction from the rotational magnetic field in the nonmagnetic particle, and moving the nonmagnetic particle on the nonmagnetic base material.

9. A method for manipulation using a rotational magnetic field according to claim 8, wherein the magnetic fluid has ferromagnetic particles of 1 nm to 10 nm dispersed in a liquid solvent.

FIG. 1

## FIG. 2

FIG. 3

FIG. 4

(a)　　　　　　　　(b)　　　　　　　　(c)

## FIG. 5

RATIO $\Omega_H$ BETWEEN TRANSLATIONAL VELOCITY OF
SINGLE PARTICLE AND ROTATION VELOCITY OF TWO
MAGNETIC PARTICLES

## FIG. 6

FIG. 7

FIG. 8(b)

FIG. 8(d)

FIG. 8(a)

FIG. 8(c)

FIG. 9

FIG. 10

**INTERNATIONAL SEARCH REPORT**

| | International application No. |
|---|---|
| | PCT/JP2005/015103 |

A.  CLASSIFICATION OF SUBJECT MATTER
*B01J19/08*(2006.01), *B82B3/00*(2006.01), *G01N37/00*(2006.01)

According to International Patent Classification (IPC) or to both national classification and IPC

B.  FIELDS SEARCHED

Minimum documentation searched (classification system followed by classification symbols)
*B01J19/08*(2006.01), *B82B3/00*(2006.01), *G01N37/00*(2006.01)

Documentation searched other than minimum documentation to the extent that such documents are included in the fields searched
Jitsuyo Shinan Koho        1922-1996   Jitsuyo Shinan Toroku Koho   1996-2005
Kokai Jitsuyo Shinan Koho  1971-2005   Toroku Jitsuyo Shinan Koho   1994-2005

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
|---|---|---|
| E,A | JP 2005-246538 A  (Toyo University),<br>15 September, 2005 (15.09.05),<br>Full text; all drawings<br>(Family: none) | 1-9 |
| A | JP 2004-309189 A  (Toyo University),<br>04 November, 2004 (04.11.04),<br>Full text; all drawings<br>(Family: none) | 1-9 |
| E,X | JP 2005-246539 A  (Toyo University),<br>15 September, 2005 (15.09.05),<br>Full text; all drawings<br>(Family: none) | 1-9 |

☐  Further documents are listed in the continuation of Box C.     ☐  See patent family annex.

| | |
|---|---|
| * Special categories of cited documents:<br>"A" document defining the general state of the art which is not considered   to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>10 November, 2005 (10.11.05) | Date of mailing of the international search report<br>22 November, 2005 (22.11.05) |
|---|---|
| Name and mailing address of the ISA/<br>    Japanese Patent Office | Authorized officer |
| Facsimile No. | Telephone No. |

Form PCT/ISA/210 (second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **G. HELGESEN ; PIERANSKI.** Dynamic behavior of simple magnetic hole systems. *Physical Review,* 1990, vol. A 42, 7271-7280